# EUROPÄISCHE PATENTSCHRIFT

(11) **EP 1 496 168 B1**
(45) Veröffentlichungstag und Bekanntmachung des Hinweises auf die Patenterteilung: **21.06.2006**
(21) Anmeldenummer: 04006024.6
(22) Anmeldetag: 13.03.2004
(51) Int. Cl.: E04B 1/92, H05K 9/00, E04C 2/26

(54) **Bauelement mit einer elektrisch leitenden Schicht**
Building element with an electrically conducting layer
Elément de construction avec une couche électroconductrice

(30) Priorität: 11.07.2003 DE 10331386
(43) Veröffentlichungstag der Anmeldung: 12.01.2005
(73) Patentinhaber: HERAKLITH AG, 9702 Ferndorf (AT)
(72) Erfinder: Eusch, Ingram, 9500 Villach (AT); Mente, Markus, 9587 Riegersdorf (AT)
(74) Vertreter: Becker, Thomas

(56) Entgegenhaltungen:
- DE-U1- 8 114 969
- GB-A- 1 601 208
- US-B1- 6 512 173

## Beschreibung

Die Erfindung betrifft ein geformtes Bauprodukt, und zwar mit einem Grundkörper auf Basis unregelmäßig verteilter Holzwolle-Späne, die zumindest abschnittweise über ein Bindemittel verbunden sind.

Ein solches Bauprodukt ist als sogenanntes Holzwolle-Leichtbauelement (nachstehend auch HWL-Element genannt) seit über 100 Jahren bekannt und wird insbesondere unter der Marke "Heraklith" der Anmelderin vertrieben.

Ein HWL-Element zeichnet sich neben einer offenporigen Struktur (die Freiräume zwischen den Holzwollefasern/Holzwollespänen können beispielsweise 50-80 Vol.% betragen) durch eine relativ biegesteife Struktur aus.

Die Bauprodukte sind in verschiedenen Größen, Formen und Konfektionierungen, überwiegend aber in Plattenform im Handel erhältlich. Sie können auch Bestandteil von Verbund-Elementen sein.

Die Rohdichte bekannter HWL-Elemente beträgt üblicherweise bis 350 kg/m³, nach DIN 1102 geht der Rohdichte-Bereich bis mindestens 570 kg/m³, je nach dem Volumenanteil an Freiräumen zwischen den Feststoffanteilen des Bauproduktes.

Die Holzwolle-Späne weisen üblicherweise eine Länge von mehr als 8 cm, eine Breite von 1-5 mm und eine Dicke von 0,2-0,5 mm auf.

Aufgrund einer erheblichen offenen Mikroporosität (sogenannte Zellen) der Holzspäne ergibt sich eine relativ hohe Oberfläche der einzelnen Fasern/Späne, wodurch eine Verbindung mit Hilfe des genannten Bindemittels erleichtert wird. Man spricht von einer "Inkrustierung" der Späne durch das Bindemittel, also eine Art Oberflächenbeschichtung der Späne durch das Bindemittel, beispielsweise ein magnesitisches Bindemittel. Das Bindemittel wird mit einer Flüssigkeit wie Wasser angemacht und in viskoser Form zwischen das unregelmäßig dreidimensional verteilte Gerüst an Holzwollespänen eingebracht. Beispielsweise mit Hilfe eines Niederhalters wird sichergestellt, dass das Produkt beim Aushärten die gewünschte definierte Geometrie beibehält.

Bauprodukte (HWL-Elemente) der genannten Art, siehe beispielsweise GB-A-1 601 208, können für statische, bauphysikalische und dekorative Zwecke verwendet werden, beispielsweise als verlorener Schalungskörper beim Gießen von Beton, als Schallschutz-Elemente in privaten, öffentlichen und gewerblichen Gebäuden, aber auch als dekorative Verkleidungselemente insbesondere an Decken und Wänden.

Ziel der Erfindung ist es, das Anwendungsspektrum der bekannten Bauprodukte auf Basis von gebundenen Holzwollespänen zu erweitern.

Ein wesentlicher Aspekt dabei ist es, dem unter dem Stichwort "Elektrosmog" diskutierten verstärkten Auftreten elektromagnetischer Strahlung Rechnung zu tragen.

Elektromagnetische Strahlen treten zum Beispiel als Hochfrequenzstrahlen im Bereich Rundfunk, Radar oder Mobilfunk in einem Umfang auf, wie dies vor wenigen Jahren noch unvorstellbar war. Praktisch flächendeckend existieren Sende- und Empfangs- sowie Verstärkungsanlagen für den Mobilfunk.

Ob und inwieweit die Gesundheit des Menschen durch dieses Strahlung geschädigt werden kann ist wissenschaftlich noch nicht oder zumindest nicht sicher erforscht. Es existieren jedoch europäische Richtlinien für die elektromagnetische Verträglichkeit, die zeigen, dass technische Lösungen verlangt werden, die potentielle Gefahr durch elektromagnetische Strahlung zu reduzieren.

In der DE 197 47 622 A1 wird eine Dämmplatte aus Mineralwolle mit folgenden Merkmalen vorgeschlagen: Mindestens einer auf der Mineralwolle aufgebrachten offenen elektrisch leitenden Schicht aus Metalldrahtgeflecht, perforierter oder gelochter Metallfolie, metallischer Armierung oder einem Vlies mit elektrischer Leitfähigkeit. Die Veröffentlichung sagt nichts über Art und Weise der Konfektionierung des Drahtgeflechtes beziehungsweise der elektrisch leitenden Komponenten. Offensichtlich ergeben sich auch Schwierigkeiten bei der Konfektionierung, weil entsprechende Produkte bisher auf dem Markt kaum verfügbar sind.

Bauprodukte der eingangs genannten Art weisen neben der Holzwolle ein Bindemittel, in der Regel ein anorganisches Bindemittel auf, welches flüssig bis viskos verarbeitet wird und anschließend durch Hydratation oder chemisch aushärtet und dabei die Holzwolle (Holzwollespäne) untereinander zu einem formstabilen Bauprodukt verbindet.

Bei der Erfindung werden die Eigenschaften und Funktion des Bindemittels in doppelter Hinsicht genutzt, nämlich ergänzend zur entsprechenden Konfektionierung elektrisch leitender Komponenten in oder an dem Bauprodukt.

So können beispielsweise elektrisch leitende, diskrete Teile wie Metallspäne, Metallstreifen oder dergleichen problemlos während des Herstellungsprozesses des Holzwolle-Bauproduktes eingestreut oder aufgestreut werden. Das noch nicht abgebundene Bindemittel sorgt für eine Aufnahme und Fixierung der einzelnen Teilchen.

Analog gilt dies für Strukturkörper wie Gitter, Gewirke oder Geflechte, die während des Herstellungsprozesses auf- oder eingelegt werden können. Zum Beispiel kann zunächst eine Teilschicht aus Holzwolle und Bindemittel erstellt werden. Danach wird eine Metallfolie oder ein Metallgitter aufgelegt. Dieses wird unmittelbar durch das Bindemittel "festgehalten" und anschließend wird eine weitere Schicht aus Holzwollespänen und Bindemittel aufgebracht, wobei alle Schichten unmittelbar miteinander über das Bindemittel verbunden werden.

Selbstverständlich sind auch Kombinationen der vorgenannten Maßnahmen möglich.

Danach betrifft die Erfindung in ihrer allgemeinsten Ausführungsform ein geformtes Bauprodukt gemäß Anspruch 1.

Bei diesem Bauprodukt entfällt jede separate Maßnahme zur Einbindung oder Fixierung der elektrisch leitenden Komponente(n), wie dies im Stand der Technik offensichtlich notwendig ist.

Egal, ob die elektrisch leitenden Teile im Oberflächenbereich oder innerhalb des Bauproduktes konfektioniert werden. Stets lassen sie sich über die Bindemittelkomponente unmittelbar im Gesamtkörper fixieren, und zwar sowohl beim Einbringen (Auftragen) als auch am späteren fertigen Produkt. Die elektrisch leitenden Teile können vom Bindemittel umhüllt sein oder partiell über die Bindemittelphase vorstehen.

Die elektrisch leitende Komponente kann in beliebiger geometrischer Form konfektioniert sein. Beispielhafte Formen umfassen: Fasern, Stäbe, Spiralen, Perlen, Blätter, Scheiben, Kegel, Fäden, Folien, Gewirke, Geflechte, Lochstreifen, Gitter, Vliese.

Insbesondere bei der Verwendung einzelner (kleinerer) diskreter Komponenten wie Fasern, Perlen oder dergleichen erhöht sich die Abschirmwirkung des fertigen Produktes nachhaltig, wenn die einzelnen Komponenten untereinander eine elektrische Verbindung haben. Da diese über das Bindemittel beziehungsweise die Holzwollefasern allenfalls in verringertem Umfang bereitgestellt werden kann folgt daraus, dass je nach Anwendungsbereich und erwünschter Abschirmwirkung der Massenanteil an den genannten Komponenten einzustellen ist.

Ein wesentlicher Vorteil beim erfindungsgemäßen Produkt besteht darin, dass die einzelnen Komponenten über eine mehr oder weniger durchgehende Bindemittelphase bereits eine mehr oder weniger durchgehende elektrisch leitende Schicht ausbilden. Der Effekt wird verstärkt, sofern die einzelnen Komponenten untereinander Körperkontakt haben, wie dies bei den Maschen eines Gitters oder Gewebes der Fall ist.

Soweit das Bauprodukt sich dadurch auszeichnen soll, dass eine elektrisch leitende Schicht ausgebildet wird, die "im Wesentlichen parallel zu einer Sichtoberfläche des Bauproduktes verläuft", so bedeutet dies, dass die Schicht im Wesentlichen senkrecht zur Richtung der auftreffenden elektromagnetischen Strahlen verläuft. Dies ist nicht im geometrischen, sondern im technischen Sinne zu verstehen. Wie bereits ausgeführt ergibt sich bereits durch das dreidimensional verteilte Bindemittel eine dreidimensionale Verteilung der elektrisch leitenden Komponenten, die letztendlich aber auch wiederum im Wesentlichen parallel zur Sichtoberfläche des Bauproduktes verläuft.

Die dreidimensionale Verteilung (also auch senkrecht zur Sichtoberfläche des Bauproduktes) erhöht sogar die elektromagnetische Abschirmwirkung.

Die Werkstoffauswahl für die elektrisch leitenden Komponenten weist keine Beschränkung auf. Insbesondere Metalle, Kohlenstoff oder Halbleiter sind geeignet. Besonders vorteilhaft können Abfallstoffe, wie Metallspäne oder dergleichen eingesetzt werden. Die Abschirmwirkung von Kupfer ist besonders groß.

Die elektrisch leitende Schicht kann so ausgebildet sein, dass sie unmittelbar oder mittelbar mit einer elektrisch leitenden Schicht eines weiteren Bauproduktes der genannten Art elektrisch verbunden werden kann. Dies ist wichtig, um zum Beispiel bei der Verkleidung von Wänden oder Decken eine - aus elektrischer Sicht - durchgehende Schicht auszubilden und damit keine "Lücken" in der Abschirmfläche zuzulassen.

Zu diesem Zweck kann insbesondere eine Seitenfläche des Bauproduktes, welche gegen eine korrespondierende Seitenfläche eines weiteren Bauproduktes anliegt, mit einer entsprechenden elektrisch leitenden Schicht ausgebildet sein. Dabei kann die elektrisch leitende "Hauptschicht", die sich im Wesentlichen parallel zur Sicht oberfläche des Bauproduktes erstreckt, mit dieser zusätzlichen elektrisch leitenden Schicht (im Seitenbereich) einteilig sein.

Nach einer weiteren Ausführungsform der Erfindung ist die elektrisch leitende Schicht Teil eines in oder am Baukörper verlaufenden elektrisch leitenden Käfigs, mit dem elektromagnetische Felder in besonders vorteilhafter Weise neutralisiert werden können.

Soweit die elektrisch leitende Komponente als flächiger Körper zum Beispiel auf eine Oberfläche des Holzwolleelementes aufgebracht wird kann diese Schicht größer als das eigentliche Holzwolleelement sein und beispielsweise an zwei, aneinander anschließenden Rändern überstehen, sodass sich nach dem Verlegen mehrerer solcher Bauprodukte eine unmittelbar durchgehende elektrische Verbindung ergibt.

Es gehört zu der aufgabengemäßen Funktion, dass das Bauprodukt so ausgebildet ist, dass die elektrisch leitende Schicht geerdet werden kann.

Das Produkt behält die Eigenschaften eines konventionellen HWL-Elementes. Es bietet zusätzlich eine hohe elektromagnetische Verträglichkeit. Es ist leicht herstellbar. Bestehende Produktlinien müssen lediglich ergänzt, nicht geändert werden. Insoweit wird hinsichtlich der Herstellung auf den Stand der Technik Bezug genommen. Wie ausgeführt können die elektrisch leitenden Komponenten während der Herstellung eingestreut, eingeschoben, aufgelegt oder aufgetragen werden. Dies kann kontinuierlich oder diskontinuierlich erfolgen. Beispielsweise kann ein Geflecht, welches auf eine Oberfläche aufgelegt werden soll, von einer Rolle abgewickelt werden.

Über die "Maschenweite", also den Abstand elektrisch leitender Teile innerhalb des Bauproduktes lässt sich der Grad der elektromagnetischen Abschirmung individuell einstellen.

Soweit die elektrisch leitenden Komponenten im oder auf der Rückseite des Bauproduktes angebracht werden ändert sich am optischen Gesamteindruck gar nichts.

In der Regel genügt es, wenn die elektrisch leitenden Komponenten, soweit sie als Drähte, Stifte, Fäden, etc. konfektioniert sind, eine Breite oder einen Durchmesser bis 1 mm aufweisen. Dies gilt analog für die Dimensionierung einzelner Abschnitte eines Geflechtes oder eines Gitters. Folien können sehr dünn, bis in den Bereich von µm dickenmäßig reduziert werden, ohne die Abschirmwirkung zu reduzieren.

Die Erfindung wird nachstehend anhand verschiedener Ausführungsbeispiele näher erläutert.

Dabei zeigen - jeweils in stark schematisierter Darstellung -
- Figur 1:: Eine Aufsicht auf die Sichtfläche eines Bauproduktes
- Figur 2:: Eine Ansicht einer Seitenfläche eines Bauproduktes
- Figur 3:: Eine Aufsicht auf die Sichtfläche eines weiteren Bauproduktes
- Figur 4:: Eine Seitenansicht eines weiteren Bauproduktes
- Figur 5:: Eine auseinandergezogene Darstellung einer Wandverkleidung mit einer weiteren Ausführungsform von HWL-Elementen

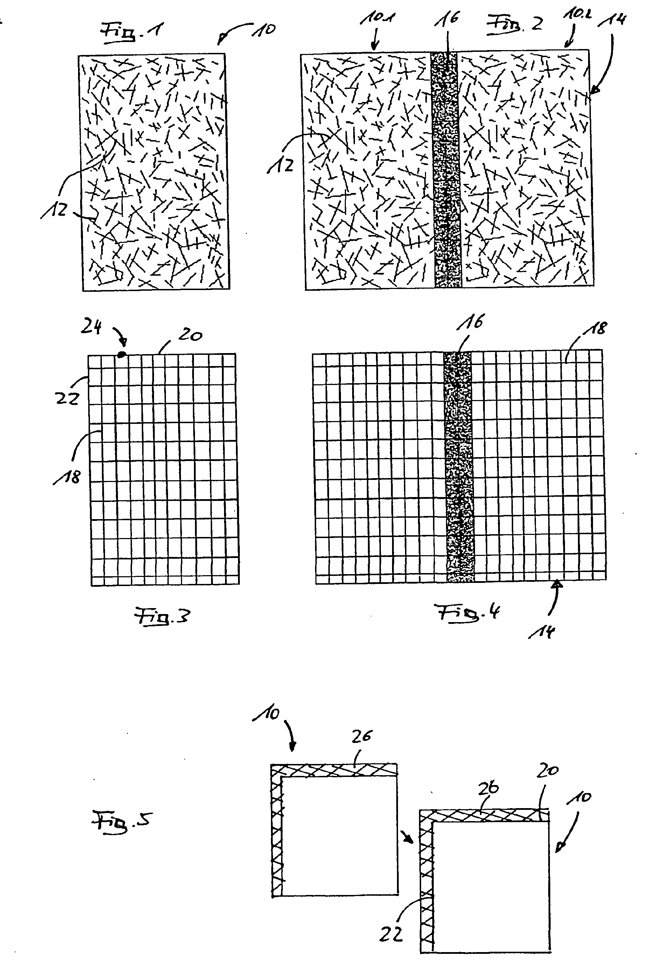

In den Figuren sind gleiche oder gleichwirkende Bauteile mit gleichen Bezugsziffern dargestellt. Ausdrücklich wird darauf hingewiesen, dass die Zeichnungen in keiner Weise maßstäblich sind. In Figur 1 bezeichnet das Bezugszeichen 10 eine Bauplatte, die sich von einer bekannten Holzwolle-Leichtbauplatte lediglich dadurch unterscheidet, dass sie zusätzlich Stahlfasern 12 umfasst, die unregelmäßig verteilt im Bauprodukt vorliegen. Die Stahlfasern 12 werden dabei überwiegend durch das Bindemittel fixiert, welches auch der Fixierung der Holzwolle-Späne dient.

Figur 1 zeigt - stark schematisiert - dass zahlreiche der Metallspäne 12 untereinander Kontakt haben, entweder unmittelbar oder mittelbar über das Bindemittel, sodass die dargestellte Platte eine mehr oder weniger durchgehende elektrisch leitende Schicht (gebildet von den Metallspänen 12) aufweist, die parallel zur Sichtoberfläche verläuft.

Die in Figur 1 ausschließlich erkennbare Sicht-Oberfläche des Bauproduktes 10 ist im Ausführungsbeispiel nach Figur 2 mit 14 angegeben. Insoweit zeigt Figur 2 die Verteilung der Kupferfasern 12 über die Dicke des plattenförmigen Elementes 10. Zusätzlich ist etwa mittig (über die Dicke betrachtet) eine gelochte Metallfolie 16 zu erkennen, die das Bauprodukt in zwei Abschnitte 10.1, 10.2 teilt, wobei jeder dieser Teile 10.1, 10.2 im Prinzip dem Bauprodukt nach Figur 1 entspricht.

Die gelochte Folie 16 steht wiederum zumindest teilweise in elektrisch leitender Verbindung zu den Metallfasern 12. Es würde der Erfindung entsprechen, beim Beispiel nach Figur 2 auf die Metallspäne zu verzichten oder die Späne nur in dem Bereich anzuordnen, wo die gelochte Folie 16 verläuft.

Beim Ausführungsbeispiel nach Figur 3 wird die elektrisch leitende Komponente von einem Metallgitter 18 gebildet, welches auf einer Hauptoberfläche (Sichtfläche in Figur 3) und zwei aneinander angrenzenden Seitenflächen 20, 22 verläuft. Bei der späteren Montage, beispielsweise an einer Wand, wird die in Figur 3 erkennbare Sichtfläche wandseitig verlaufen. Eine elektrisch leitende durchgehende Verbindung zu benachbarten Bauprodukten ergibt sich über die Gitter in den Randbereichen 20, 22. Mit 24 ist schematisch ein Erdungsanschluss dargestellt.

Figur 4 zeigt eine Ansicht auf die Seite 20, sodass die in Figur 3 dargestellte Sichtfläche 14 in Figur 4 unten verläuft. Zu erkennen ist, dass das Metallgitter 18 sich auch über die gesamte Seitenfläche 20 erstreckt und dabei eine Metallfolie 16 überdeckt, die analog zum Ausführungsbeispiel nach Figur 2 im Bauprodukt, aber senkrecht zur Sichtfläche 14 verläuft, wodurch eine käfigartige Struktur der elektrisch leitenden Komponenten gebildet wird.

In Figur 5 sind zwei HWL-Elemente 10 dargestellt, die jeweils aus einem quaderförmigen Grundkörper bestehen (ohne Schraffierung), auf dessen Rückseite ein Metallvlies 26 aufliegt (und über das Bindemittel des HWL-Elementes festgehalten wird). Das Metallvlies 26 steht über zwei Seitenkanten 20, 22 vor. Beim Verlegen auf einer Wand wird entsprechend ein benachbartes Element auf den überstehenden Randstreifen aufgelegt, sodass es zu einer durchgehenden metallischen und damit elektrisch leitenden Verbindung zwischen benachbarten Bauprodukten 10 kommt.

Die Befestigung der Bauprodukte an der Wand kann mechanisch, über Kleber oder in einem Mörtelbett erfolgen.

## Patentansprüche

1. Geformtes Bauprodukt (10) mit folgendem Aufbau:
a) Einem Grundkörper auf Basis unregelmäßig verteilter Holzwolle-Späne, die zumindest abschnittweise über ein Bindemittel verbunden sind,
b) mindestens einer elektrisch leitenden Komponente (12), (16), (18), (26), die
c) zumindest partiell am oder im Bauprodukt (10) durch das Bindemittel fixiert und
d) so angeordnet ist, dass mindestens eine elektrisch leitende Schicht ausgebildet wird, die im Wesentlichen parallel zu einer Sichtoberfläche (14) des Bauproduktes (10) verläuft **dadurch gekennzeichnet, dass** die electrisch leitende Schicht einen Erdungsanschluss (24) aufweist.

2. Bauprodukt nach Anspruch 1, bei dem die Komponente (12), (16), (18), (26) mindestens eine der folgenden geometrischen Formen aufweist: Faser, Stab, Spirale, Perle, Blatt, Scheibe, Kegel, Faden, Folie, Gewirke, Geflecht, Lochstreifen, Gitter, Vlies.

3. Bauprodukt nach Anspruch 1, bei dem die Komponente (12), (16), (18), (26) aus mindestens einem der folgenden Werkstoffe besteht: Metall, Kohlenstoff, Halbleiter.

4. Bauprodukt nach Anspruch 1, bei dem die elektrisch leitende Schicht so ausgebildet ist, dass sie unmittelbar oder mittelbar mit einer elektrisch leitenden Schicht eines weiteren Bauproduktes (10) gemäß Anspruch 1 elektrisch verbindbar ist.

5. Bauprodukt nach Anspruch 1, bei dem die im Wesentlichen parallel zu einer Sichtoberfläche (14) des Bauproduktes (10) verlaufende Schicht sich entlang mindestens eines an die Sichtoberfläche (14) anschließenden Oberflächenbereiches (20, 22) des Bauproduktes (10) anschließt.

6. Bauprodukt nach Anspruch 1, bei dem die elektrisch leitende Schicht Teil eines in oder am Baukörper (10) verlaufenden elektrisch leitenden Käfigs ist.

## Claims

1. Shaped construction product (10) designed as follows:
a) a basic body comprising irregularly dispersed wood-wool fibres, being combined at least partially by a binder,
b) at least one electrically conductive component (12), (16),(18), (26), being
c) fixed at the construction product (10) or in it by said binder at least partially, and
d) arranged in such a way that at least one electrically conductive layer is formed, which is arranged mostly parallel to an outer surface (14) of the construction body **characterized in that** the electrically conductive layer comprises a grounding connection.

2. Construction body according to claim 1, the component (12), (16), (18), (26) of which has at least one of the following geometric shapes: fibre, rod, spiral, perle, sheet, disc, cone, thread, foil, fabric, punched tape, grid, web.

3. Construction body according to claim 1, the component (12), (16), (18), (26) of which is made of at least one of the following materials: metal, carbon, semiconductor.

4. Construction body according to claim 1, the electrically conductive layer of which is designed such that it can be electrically connected directly or indirectly with an electrically conductive layer of a further construction body (10) according to claim 1.

5. Construction body according to claim 1, wherein the layer running predominantly parallel to an outer surface (14) of the construction body (10) follows at least one surface portion (20, 22) following the outer surface (14) of the construction body.

6. Construction body according to claim 1, wherein the electrically conductive layer is part of a cage running in or along the construction body and being electrically conductive.

## Revendications

1. Produit de construction (10) façonné comportant la structure suivante :
a) un corps de base, à base de copeaux de laine de bois irrégulièrement répartis, qui sont liés au moins par zones par un liant,
b) au moins un composant électroconducteur (12), (16), (18), (26), qui
c) est fixé au moins partiellement sur ou dans le produit de construction (10) par le liant et
d) est agencé de manière à former au moins une couche électroconductrice qui est sensiblement parallèle à une surface visible (14) du produit de construction (10),
**caractérisé en ce que** la couche électroconductrice comporte un branchement à la terre (24).

2. Produit de construction selon la revendication 1, dans lequel le composant (12), (16), (18), (26) a au moins une des formes géométriques suivantes : fibre, barre, spirale, perle, feuille, disque, cône, fil, feuille, maillage, treillis, bande perforée, grille, non-tissé.

3. Produit de construction selon la revendication 1, dans lequel le composant (12), (16), (18), (26) est formé par au moins l'un des matériaux suivants : métal, carbone, semi-conducteur.

4. Produit de construction selon la revendication 1, dans lequel la couche électroconductrice est réalisée de telle sorte qu'elle peut être reliée électriquement directement ou indirectement à une couche électroconductrice d'un autre produit de construction (10) selon la revendication 1.

5. Produit de construction selon la revendication 1, dans lequel la couche sensiblement parallèle à une surface visible (14) du produit de construction (10) est raccordée le long d'au moins une zone de surface (20, 22) du produit de construction (10), raccordée à la surface visible (14).

6. Produit de construction selon la revendication 1, dans lequel la couche électroconductrice est une partie d'une cage électroconductrice qui s'étend dans ou sur le produit de construction (10).
